(19) Europäisches Patentamt
European Patent Office
Office européen des brevets

(11) Publication number: 0 377 332 A2

# (12) EUROPEAN PATENT APPLICATION

(21) Application number: 89313680.4

(22) Date of filing: 28.12.89

(51) Int. Cl.5: H01B 3/40, H05K 3/28

(30) Priority: 28.12.88 JP 333744/88
28.12.88 JP 333745/88
28.12.88 JP 333746/88
06.02.89 JP 27295/89

(43) Date of publication of application:
11.07.90 Bulletin 90/28

(84) Designated Contracting States:
BE DE FR GB

(71) Applicant: SOMAR CORPORATION
11-2, Ginza 4-chome Chuo-ku
Tokyo(JP)

(72) Inventor: Shirose, Toru
West-Town 207 1-3-45 Gamounishimachi
Koshigaya-shi Saitama-ken(JP)
Inventor: Yamamoto, Shinichi
7-13-7 Yashio
Yashio-shi Saitama-ken(JP)

(74) Representative: Allam, Peter Clerk et al
LLOYD WISE, TREGEAR & CO. Norman
House 105-109 Strand
London WC2R 0AE(GB)

## (54) Laminate film having a thermosetting resin layer and use thereof for forming electrically insulating layer over conducting surface.

(57) A laminate film is disclosed which includes a substrate film and a thermosetting resin film formed of a thermosetting epoxy resin and supported on one side surface of the substrate film. An electrically insulating layer is formed over a conducting surface using the laminate film by a method which includes the steps of hot bonding the thermosetting resin film to the conducting surface, removing the substrate film, and curing the thermosetting resin film to form the insulating layer of the cured epoxy resin.

EP 0 377 332 A2

# LAMINATE FILM HAVING A THERMOSETTING RESIN LAYER AND USE THEREOF FOR FORMING ELECTRICALLY INSULATING LAYER OVER CONDUCTING SURFACE

This invention relates to a laminate film and to a method of forming an electrically insulating layer over an electrically conducting surface using the laminate film.

For the formation of an electrically insulating layer over an electrically conducting surface, such as in manufacturing multi-layered, printed circuit boards or in effecting electromagnetic shielding of printed circuit boards, there has been hitherto employed a method in which a coating composition containing a phenol resin, an epoxy resin or the like resin is applied on a surface to be insulated and the resulting coat is dried and thermally treated. In the case of forming an electromagnetic-shield layer, a conductive coat is subsequently applied over the resin coating. The conventional method has a problem because it is difficult to form an insulating layer having a large thickness. Further, the formation of the insulating layer requires a number of steps and is time consuming.

The present invention has been made in view of the foregoing problems of the conventional method. In accordance with one aspect of the present invention there is provided a laminate film comprising a substrate film and a thermosetting resin film formed of a thermosetting resin composition containing an epoxy resin and supported on one side surface of said substrate film.

In another aspect, the present invention provides a method of forming an electrically insulating layer over an electrically conducting surface, comprising the steps of:

(a) providing a laminate film including a substrate film and a thermosetting resin film supported on one side of said substrate film and formed of a composition containing an epoxy resin;

(b) superposing said laminate film on the conducting surface with said thermosetting resin film being in contact with the conducting surface;

(c) heating said thermosetting resin film at a temperature sufficient to soften said thermosetting resin film so that said thermosetting resin film is bonded to said conducting surface;

(d) then removing said substrate film from said thermosetting resin film; and

(e) then heating said thermosetting resin film at a temperature and for a period of time sufficient to cure said thermosetting resin film, thereby to form the insulating layer formed of said cured film.

The present invention also provides a method of forming an electrically insulating layer over an electrically conducting surface with an electrically conducting layer being provided on the insulating layer, comprising the steps of:

(a) providing a laminate film including an electrically conducting substrate film, and a thermosetting, epoxy resin film supported on one side of said substrate film;

(b) superposing said laminate film on the conducting surface with said thermosetting resin film being in contact with the conducting surface;

(c) heating said thermosetting resin film at a temperature sufficient to soften said thermosetting resin film so that said thermosetting resin film is bonded to said conducting surface; and

(d) then heating said thermosetting resin film at a temperature and for a period of time sufficient to cure said thermosetting resin film, thereby to form the insulating layer formed of said cured film on the conducting surface with said conducting substrate being provided on the insulating layer and serving as the conducting layer.

The present invention will now be described in detail below with reference to the accompanying drawing, in which the sole FIGURE is a perspective view schematically illustrating a rolled laminate film according to the present invention.

The laminate film according to the present invention is comprised of a substrate film having supported thereon a thermosetting resin film. The substrate film for supporting the thermosetting resin film thereon may be a synthetic resin film, a metal film or a metal-deposited resin film. The synthetic resin film may be formed of a polyethylene, a polypropylene, a polystyrene, a polyvinyl chloride, a polyvinylidene chloride, a polyamide, a polyester, a polyimide, a polysulfone, a polyacrylate, a polyether amide or a polycarbonate and preferably has a thickness of 5-250 µm, more preferably 10-125 µm. The metal film may be a copper foil, an aluminum foil or a tin foil. The metal deposited film may be of a type in which silver, aluminum, tin or the like metal is vacuum deposited on a synthetic resin film such as described immediately above. The thickness of the metal film or a vacuum deposited metal layer is generally 0.1-100 µm.

The laminate film of the present invention may be obtained by applying a coating composition to a substrate film at room temperature or at an elevated temperature, followed by solidification of the resulting coat. When the coating is conducted at room temperature, the resulting coat is preferably heated to permit curing of the composition to proceed to some extent and is then cooled to room temperature for

solidification. When the coating is conducted at an elevated temperature, cooling of the resulting coat is sufficient to effect the solidification. When the composition contains a solvent, the resulting coat is dried to remove the solvent by vaporization. The thus obtained coated film on the substrate film is softened or melted upon heating but is set upon further heating. The thermosetting resin film has preferably a softening point of 0-200 °C, more preferably 20-150 °C. The thickness of the thermosetting resin film is determined in view of the object of use thereof but is generally 10-500 µm, preferably 20-200 µm.

The thermosetting resin composition to be coated on the substrate film for the formation of the thermosetting resin film should be a liquid at room temperature or at an elevated temperature (generally up to about 200 °C) at which the coating of the composition is carried out. Details of such a composition will now be described below.

The thermosetting coating composition suitable for use in the present invention includes an epoxy resin and a curing agent. The epoxy resin is suitably a liquid epoxy resin having two or more epoxy groups in its molecule. Examples of suitable epoxy resins include glycidyl ethers of bisphenol A, bisphenol F, bisphenol AD, brominated bisphenol A, glycerin and a polyalkylene oxide; glycidyl esters of dimer acid and isophthalic acid; epoxidized polybutadiene obtained by reaction of polybutadiene with peracetic acid; and mixtures thereof. Above all, the use of glycidyl ethers of bisphenol A, bisphenol F and bisphenol AD is particularly preferred.

The epoxy resin may be used in conjunction with an epoxy compound capable of lowering the viscosity of the resin composition. Further, a crystalline or solid epoxy resin may be added to the composition as long as it can be dissolved in the liquid epoxy resin. Examples of such solid epoxy resins include glycidyl ethers of resorcin and hydroquinone.

The curing agent to be used in the present invention is preferably a latent curing agent which can react with an epoxy resin at an elevated temperature of, for example 60 °C or more, preferably 100 °C or more. Such a latent curing agent may be a nitrogen-containing curing agent, a boron trifluoride-amine complex, an organometallic compound, an acid anhydride, a phenol compound, a novolak phenol resin. Of these the use of a nitrogen-containing compound is especially preferred. Illustrative of suitable nitrogen-containing compounds are dicyanodiamide, a guanamine (e.g. acetoguanamine or benzoguanamine), a hydrazide (e.g. adipodihydrazide, stearodihydrazide, isophthalodihydrazide or sebacohydrazide), a triazine compound (e.g. 2,4-dihydrazide-6-methylamino-S-triazine) or an imidazole or its derivative is preferably used in the present invention.

It is preferred that a curing accelerator be used in conjunction with the above curing agent. Such a promoter may be, for example, (1) a urea compound such as 3-substituted-1,1-dimethylureas, (2) a solid solution of 1,8-diazabicyclo(5,4,0)undecene-7 and a phenol novolak and (3) an amine adduct obtained by reacting a compound having at least two epoxy groups with a compound having both a hydroxyl group and a tertiary amino group and with an organic compound (except those having an epoxy group or a tertiary amino group) having at least two active hydrogen atoms.

Examples of suitable urea compounds are 3-(3,4-dichlorophenyl)-1,1-dimethylurea, 3-(p-chlorophenyl)-1,1-dimethylurea, 3-phenyl-1,1-dimethylurea, N,N′-(4-methyl-1,3-phenylene)-bis(N,N′-dimethylurea) and 5-(N,N′-dimethylureido)-1(N″,N″-dimethylureidomethyl)-1,3,3-trimethylcyclohexane.

The solid solution may be obtained by heating a mixture of 1,8-diaza-bicyclo(5,4,0)undecene-7 with a phenol novolak for reaction therebetween, cooling the reaction product, and pulverizing the cooled solids. The phenol novolak is a condensation product obtained by reacting a phenol derivative with an aldehyde. Examples of the phenol derivatives include phenol, alkylphenols, alkoxyphenols, halogenated phenols, resorcinol and bisphenol A. Of these, phenol, p-tertbutylphenol and bisphenol A are particularly preferred. Examples of the aldehyde include furfuraldehyde, chloral, acetoaldehyde or formaldehyde. The content of the undecene-7 in the solid solution is preferably 10-50 % by weight.

Examples of the amine adducts include polyaddition reaction products obtained from (i) 2,3-bis{4-(2,3-epoxypropoxy)phenyl}propane, 1,3-bis{4-[4-(2,3-epoxypropoxy)-α,α -dimethylbenzyl]phenoxy}-2-propanol, (ii) condensation products obtained from phenol, formaldehyde and dimethylamine, (iii) adducts of 2-alkyl-(with 1-3 carbon atoms)imidazole or 2-alkyl(with 1-3 carbon atoms)-4-methylimidazole and 2,3-epoxypropyl phenyl ether and (iv) piperazine.

In the present invention a maleimide-triazine resin is preferably used as a curing agent for the epoxy resin. The maleimide-triazine resin is an addition polymerization type thermosetting polyimide resin having cyanato groups and comprising a maleimide component and a triazine resin component. It can be obtained by reacting a polyfunctional maleimide compound with a polyfunctional cyanate compound in the presence or absence of a catalyst under heating. In this case, the cyanate compound forms a triazine ring upon being heated. As the catalyst for this reaction, an organic metal salt, a tertiary amine, etc. may be used.

As the aforesaid polyfunctional maleimide compound, there can be used, for example, those which are

represented by the following general formula (I):

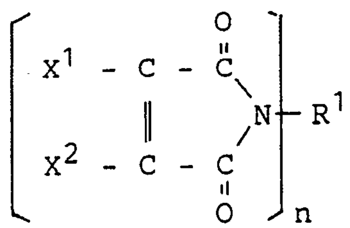

(I)

wherein $R^1$ represents an aromatic or alicyclic organic group having a valence number of 2 to 5, preferably 2, $X^1$ and $X^2$, independently from each other, represent hydrogen, halogen or alkyl, and n represents an integer of 2 to 5 corresponding to the valence number of $R^1$.

The polyfunctional maleimide compound represented by the foregoing general formula (I) can be prepared by reacting a maleic anhydride compound with a polyvalent amino compound in a conventional manner to form a maleamic acid compound, subjecting the maleamic acid compound to dehydrative cyclization. As the polyvalent amino compound, there may be used, for example, phenylenediamine, xylylenediamide, cyclohexanediamine, 4,4′-diaminobiphenyl, bis(4-aminophenyl)methane, bis(4-aminophenyl)ether, bis(4-amino-3-methylphenyl)methane, 2,2-bis(4-aminophenyl)propane, 2,2-bis(4-amino-3-methylphenyl)propane, 2,2-bis(4-amino-3-chlorophenyl)propane and 1,1-bis(4-aminophenyl)-1-phenylethane.

As the aforesaid polyfunctional cyanate compound, there may be used, for example, those which are represented by the following general formula:

$R^2(OCN)_m$ (II)

wherein $R^2$ represents an aromatic group having a valence number of 2 to 5, preferably 2, and m represents an integer of 2 to 5 corresponding to the valence number of $R^2$.

As the polyfunctional cyanate compound represented by the above general formula (II), there may be used, for example, dicyanatobenzene, tricyanatobenzene, dicyanatonaphthalene, 4,4-dicyanatobiphenyl, bis-(4-dicyanatophenyl)methane, 2,2-bis(4- cyanatophenyl)propane, 2,2-bis(3,5-dichloro-4-cyanatophenyl)-propane, and bis(4-cyanatophenyl)ether.

In preparing the maleimide-triazine resin, the weight ratio of the maleimide compound to the cyanate compound is 10:90 to 40:60, preferably 20:80 to 30:70. If the amount of maleimide compound component is less than the lower limit of the above range, the resulting resin becomes poor in heat resistance. On the other hand, if more than the upper limit of the above range is used, the content of cyanate compound component (cyanato group: -OCN) becomes so small that the resulting resin cannot sufficiently function as a curing agent for the epoxy resin. The maleimide-triazine resin can be used in a liquid or solid state. The maleimide-triazine resin reacts as a curing agent with the epoxy resin to finally give a thermoset product having excellent moisture-proofing property and excellent insulating properties.

The amount of the curing agent is preferably 0.03-0.25 mole per one equivalent of the epoxy group of the epoxy resin. An amount of the curing agent below 0.03 mole per 1 equivalent of the epoxy groups of the epoxy resin causes lowering of the glass transition point and resistance to moisture of the cured body, and reduction of the curing rate. When the curing agent is used in excess of 0.25 mole, the preservability of the epoxy resin composition becomes poor and the cured body obtained therefrom is low in glass transition point and in resistance to moisture. The amount of the curing accelerator is preferably 1-30 parts by weight per 100 parts by weight of the epoxy resin. An amount of the curing accelerator below 1 % by weight causes reduction of the curing rate of the composition. No merits are available by the use of the curing accelerator in excess of 30 % by weight. Rather, the composition becomes unstable.

As the curing agent there may be used one which reacts with an epoxy resin at relatively a low temperature. Examples of such curing agents include aromatic polyamines such as methaphenylenediamine and diaminodiphenylsulfone. The aromatic polyamine is used in an amount so that the ratio of the equivalent of active hydrogen thereof to the equivalent of epoxy groups of the epoxy resin is in the range of 0.7-1.3, preferably 0.85-1.15.

An inorganic filler is preferably incorporated into the thermosetting coating composition of the present invention. Illustrative of the inorganic fillers are crystalline silica, fused silica, alumina, titania, calcium carbonate, talc, clay, calcium silicate, mica, glass fibers, glass powder, glass flakes and whiskers of various kinds. The amount of the inorganic filler is 5-80 %, preferably 20-75 % based on the weight of the composition (dry basis). The inorganic filler preferably has an average particle size of 5-50 μm.

In the present invention a thixotropic agent having an average particle size of 100 nm or less is

preferably used. Examples of such a thixotropic agent include super-fine silica and alumina, aluminum hydroxide, fibrous magnesium oxysulfate, powdery asbesto, fibrous silica, fibrous potassium titanate, scale-like mica, and a montmorillonite-organic salt composite so called bentonite. The thixotropic agent is used in an amount of 0.1-30 parts by weight, preferably 0.5-15 parts by weight per 100 parts by weight of the epoxy resin.

The above inorganic filler and/or the thixotropic agent are preferably pretreated with a siloxane compound. The use of the filler and thixotropic agent generally adversely affect the stability of the composition. When the filler and thixotropic agent are treated with a siloxane compound, however, the stability or shelf life is improved. Illustrative of suitable siloxane compounds are as follows:

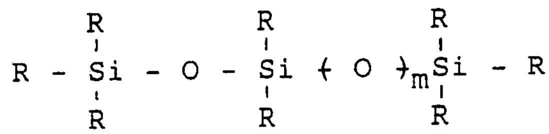

wherein R stands for a hydrocarbyl group such as methyl, ethyl, propyl, vinyl or phenyl and m is a positive integer;

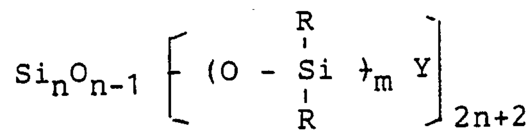

wherein R and m are as defined above and Y is hydrogen, $-OR^1$, $- R^2-CH-CH_2$, $-R^2-NH_2$, $-R^2-COOH$, $-R^2-OH$ where $R^1$ stands for a monovalent hydrocarbyl group, $R^2$ stands for a divalent hydrocarbyl group, and n is a positive integer (The hydrocarbyl group may be an aliphatic, alicyclic or aromatic);

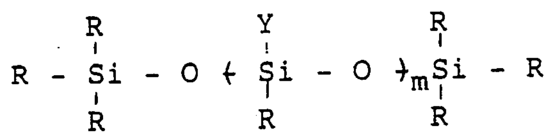

wherein R, Y and m are as defined above;

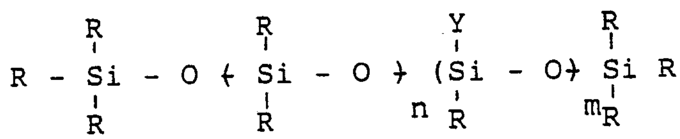

wherein R, Y, m and n are as defined above. The treatment of the filler and the thixotropic agent with the siloxane compound may be performed by mixing the filler or the thixotropic agent with a solution of the siloxane compound and, then, heating the mixture for oxidation of the siloxane compound. The above siloxane compound preferably has a viscosity of 10,000 cSt or less. The amount of the siloxane compound used is 0.1-10 parts by weight, preferably 0.5-5 parts by weight per 100 parts by weight of the filler or thixotropic agent used.

For the purpose of controlling the adhesiveness of the coating composition, a reactive diluent may be incorporated thereinto. The reactive diluent may be an epoxy compound such as butyl glycidyl ether, phenyl glycidyl ether, trimethylolpropane triglycidyl ether or a brominated phenyl glycidyl ether (bromine content: 40-50 %). Further, for the purpose of facilitating coating operation, an organic solvent may be incorporated in the thermosetting resin composition. Examples of such organic solvents include ketones such as acetone, methyl ethyl ketone and methyl isobutyl ketone, alcohols such as methanol, ethanol and isopropanol, ethers such as ethylene glycol monomethyl ether, ethylene glycol monoethyl ether and ethylene glycol dialkyl ethers, aromatic hydrocarbons such as benzene, toluene and xylene and halogenated hydrocarbons such as methylene chloride and dichloroethane.

For the purpose of increasing the thickness of the thermosetting resin film and of improving thermal stability of the laminate film, it is preferred that a polymer of a monomer with at least two acrylate or

methacrylate groups be incorporated into the thermosetting resin film. The thermosetting resin film containing such a polymer may be obtained from the above coating composition into which the acrylate or methacrylate monomer is incorporated together with a radical polymerization initiator.

More particularly, such a resin film may be formed on a substrate film by applying thereto a coating composition containing, in addition to the above-mentioned epoxy resin and curing agent, a polymerizable, polyfunctional (meth)acrylate compound and a radical polymerization initiator, and then polymerizing the polymerizable compound by heating the coat at a low temperature of, for example, 50-120 °C, preferably 70-100 °C, or by irradiating an actinic light such as ultraviolet ray, electron beam or laser beam, a polymer of the polymerizable compound is obtained with the epoxy resin remaining substantially uncured.

As the polymerizable, polyfunctional (meth)acrylate compound to be incorporated into the coating composition, monomers or oligomers having two or more acrylic ester or methacrylic ester groups are used. Illustrative of suitable polymerizable compounds are as follows:
1,4-butanediol di(meth)acrylate;
1,6-hexanediol di(meth)acrylate;
(poly)ethylene glycol di(meth)acrylate;
(poly)propylene glycol di(meth)acrylate;
neopentyl glycol di(meth)acrylate;
neopentyl glycol hydroxypivalate di(meth)acrylate;
bis (meth)acryloxyethyl hydroxyethyl isocyanurate;
tris (meth)acryloxyethyl isocyanurate;
ethylene oxide-modified bisphenol A di(meth)acrylate;
propylene oxide-modified bisphenol A di(meth)acrylate;
trimethylolpropane tri(meth)acrylate;
pentaerythritol tri(meth)acrylate;
pentaerythriaol tetra(meth)acrylate;
dipentaerythritol hexa(meth)acrylate;
an oligoester poly(meth)acrylate prepared from a polybasic acid, polyol and (meth)acrylic acid or from a polybasic acid and a hydroxyalkyl (meth)acrylate;
an epoxy poly(meth)acrylate prepared by reaction of an epoxy resin with (meth)acrylic acid; and
an urethanated poly(meth)acrylate prepared by reaction of a polyisocyanate with a polyol and a hydroxyalkyl (meth)acrylate.

In addition, a monofunctional (meth)acrylic ester compound may also be added to the coating composition as a reactive diluent. The reactive diluent is used in an amount of 0-70 % by weight, preferably 0-60 % by weight based on the total weight of the polymerizable compound and the diluent. Examples of such diluents include:
2-hydroxyethyl (meth)acrylate;
2-hydroxypropyl (meth)acrylate;
polyethylene glycol mono(meth)acrylate;
polypropylene glycol mono(meth)acrylate;
polycaprolactone mono(meth)acrylate;
methoxyethyl (meth)acrylate;
ethoxyethyl (meth)acrylate;
butoxyethyl (meth)acrylate;
methylcarbitol (meth)acrylate;
ethylcarbitol (meth)acrylate;
butylcarbitol (meth)acrylate;
(alkyl-substituted)phenoxy (poly)ethylene glycol (meth)acrylate;
(alkyl-substituted)phenoxy (poly)propylene glycol (meth)acrylate;
dicyclopentanyl (meth)acrylate;
dicyclopentenyl (meth)acrylate;
dicyclopentenyoxyethyl (meth)acrylate;
isobornyl (meth)acrylate;
tetrahydrofurfuryl (meth)acrylate;
2-hydroxy-3-phenoxypropyl (meth)acrylate;
(meth)acryloyloxyethyl monophthalate; and
acryloylmorpholine.

As the radical polymerization initiator to used in combination with the aforesaid polymerizable compound, photopolymerization initiators or thermal polymerization initiators may be used. As the

photopolymerization initiators, any of those compounds which can generate radicals upon being irradiated with actinic light such as ultraviolet rays may be used. Examples thereof include benzopohenone, benzyl, p,p′-bis(dimethylamino)benzophenone, p,p′-bis(diethylamino)benzophenone, p,p′-dibenzoylbenzene, benzoin methyl ether, benzoin ethyl ether, benzoin propyl ether, benzyl dimethyl ketal, 1-hydroxycyclohexyl phenyl ketone, 2-hydroxy-2-methyl-1-phenylpropane-1-one, 1-(4-isopropylphenyl)-2-hydroxy-2-methylpropane-1-one, anthraquinone, acetonaphthenequinone, 1-tert-butylanthraquinone, phenanthreneanthraquinone, p,p′-bis(dimethylamino)thiobenzophenone, primulin, carbazole, N-methyl-3-nitrocatbazole, xanthone, thioxanthone, chlorothioxanthone, diethylthioxanthone, diisopropylthixanthone, carbon tetrabtomide, ω,ω,ω-tribromomethyl phenyl sulfone, and ω,ω,ω-tribromomethyl phenyl ketone.

These photopolymerization initiators can be used together with a peroxide which functions as a thermal polymerization initiator to be described hereinafter.

As the thermal polymerization initiator, any of those which can generate radicals upon being heated may be used. Such thermal polymerization initiators may be, for example, azo compounds such as azobisisobutyronitrile, azobisdimethylvalelonitrile, azobis-(dimethylmethoxybutyronitrile), etc. and peroxides such as dicumyl peroxide, 1,1-bis(t-butylperoxy)-3,3,5-trimethylcyclohexane, 1,1-bis(t-butylperoxy)-cyclohexane, t-butylperoxy acetate, 2,2-bis(t-butylperoxy)butane, t-butylperoxy benzoate, n-butyl 4,4-bis(t-butylperoxy)valelate, di-t-butyldiperoxy isophthalate, methyl ethyl ketone peroxide, α,α′-bis(t-butylperoxyisopropyl)-benzene, 2,5-dimethyl-2,5-di(t-butylperoxy)hexane, t-butyl cumyl peroxide, di-t-butyl peroxide, 2,5-dimethyl-2,5-di-t-butylperoxy)hexyne-3, t-butylperoxy isobutyrate, benzoyl peroxide, acetyl peroxide, and 2,4-dichlorobenzoyl peroxide.

As the thermal polymerization initiator, those which generate radicals when heated to 50 to 150 °C, preferably about 70 to about 130 °C, are advantageously used. In the case where generation of a nitrogen gas is not desired, peroxides are preferably used in place of the azo compounds which release nitrogen gas upon being decomposed.

In a specific embodiment according to the present invention in which the coating composition to be used for the formation of the thermosetting resin film is comprised of an epoxy resin, a maleimide-triazine resin, a polymerizable, polyfunctional (meth)acrylate compound, a reactive monofunctional (meth)acrylate diluent, the content of the epoxy resin is 10 to 70 parts by weight, preferably 20 to 60 parts by weight, the content of the maleimide-triazine resin is 10 to 70 parts by weight, preferably 20 to 60 parts by weight, and the total content of the polymerizable compound and the reactive diluent is 5 to 60 parts by weight, preferably 10 to 50 parts by weight, all per 100 parts by weight of the total of the epoxy resin, maleimide-triazine resin, polymerizable compound and reactive diluent. In this case, the radical polymerization initiator is used in an amount of generally 0.1 to 10 wt %, preferably 1 to 6 wt %, based on the total amount of the epoxy resin, maleimide-triazine resin, polymerizable compound and reactive diluent.

The composition for the formation of the thermosetting resin film may further contain, as desired, a flame retarder, a flame retarding aid, a sedimentation-preventing agent, a dispersing agent or a pigment.

The thermosetting coating composition may be applied to the substrate film by a roll coating method, a curtain coating method or the like method when the composition is liquid at room temperature or by a hot melt coating method when the composition becomes liquid upon heating. The thickness of the thermosetting resin layer to be formed on the substrate film may be determined at will according to the object of the end use.

The resulting laminate film composed of the substrate film and the thermosetting resin film may be suitably used for forming an electrically insulating layer over an electrically conducting surface such as a printed circuit board. In this case, it is important that the thermosetting resin film should have such adhesiveness relative to the substrate film that, when the thermosetting resin film is bonded to a conducting surface, the thermosetting resin film sticks more strongly to the conducting surface than to the substrate film so that the substrate film may be easily removed to leave the thermosetting resin film on the conducting surface.

Adjustment of the adhesiveness of the thermosetting resin film relative to the substrate film can be made by suitably selecting the kind of polymer of the substrate film or by providing, between the thermosetting resin film and the substrate film, an intermediate layer containing a substance capable of improving the removability or peelability of the substrate film from the thermosetting resin film.

The intermediate layer may be a primer layer formed, for example, of a polyvinyl alcohol resin, a polystyrene resin, an acrylic resin, alcohol-soluble nylon, acetylcellulose or nitrocellulose. A mold releasing agent such as a wax, a higher fatty acid salt or ester, silicone oil, a silane coupling agent, a siloxane compound as mentioned above, a fluorocarbon or a silicone-type or fluorine-type surfactant may also be used for the formation of the intermediate layer.

The laminate film according to the present invention may be in the form of a cut sheet or a roll. The

latter form is preferred because of easiness in storage and transportation. In this case, it is preferable to provide a peelable, protecting layer over the surface of the thermosetting resin film, as shown in the FIGURE. Designated as 1 is a thermosetting resin film, as 2 a substrate film and as 3 is a protecting layer. In this case, it is important that the thermosetting resin film 1 should have such adhesiveness relative to the substrate film 2 that, when the laminate film is wound to form a roll, the thermosetting resin film 1 sticks more strongly to the substrate film 2 than to the protecting layer 3 so that the protecting layer 3 may be easily removed from the thermosetting resin film 1 without causing the separation of the thermosetting resin film from the substrate film 2.

The prevention of bonding between the top surface of the thermosetting resin film and the underside surface of the substrate film during rolled state can also be effected by providing, on the underside surface of the substrate film, an outer layer containing a releasing agent to prevent sticking therebetween. The releasing agent may be, for example, a wax, a higher fatty acid salt or ester, silicone oil, a silane coupling agent, a siloxane compound as mentioned above, a fluorocarbon or a silicone-type or fluorine-type surfactant. Illustrative of suitable releasing agents are dimethylpolysiloxane, methylethylpolysiloxane, methylphenylpolysiloxane, methylvinylpolysiloxane, dimethylpolysiloxane/oxyalkylene copolymers and polysiloxanes modified with long chain alkyl groups.

Formation of an insulating layer on an electrically conducting surface using the above laminate film can be effected in a simple manner by a method including the steps of covering the conducting surface with the laminate film with the thermosetting resin film thereof being in pressure contact therewith, heating the resin film to soften same, cooling the softened resin film for solidification, removing the substrate film, and curing the solidified resin film. When electromagnetic shielding is intended, a conducting layer is subsequently formed on the cured resin film. When a metal film is used as the substrate film, electromagnetic shielding may be achieved by curing the solidified resin film without removing the substrate film.

One example of application of the above-described laminate film to the formation of an insulating layer over a conducting surface of a printed wiring board will be described below.

Thermal Press Bonding of Laminate Film:

After removing a protecting layer, if any, the laminate film is superposed on the printed wiring board with the thermosetting resin film being in contact with the conducting surface of the board. The superposed board is then subjected to press bonding with heating, preferably by using a vacuum laminating method. During this treatment, the thermosetting resin film is heated to a temperature above its softening point and is pressed against the conducting surface so that the softened resin can fill substantially all depressed portions of the conducting surface to form a softened resin layer which is in intimate and close contact with the conducting surface of the printed wiring board. The layer is then cooled and solidified.

Removal of Substrate Film:

The substrate film over the solidified resin layer is then peeled away. Since that the adhesiveness of the solidified layer relative to the substrate film is weaker than that relative to the conducting surface, the substrate film may be easily removed from the solidified layer.

Curing of Solidified Layer:

The solidified layer is then heated for at a temperature and for a period of time sufficient to effect curing of the thermosetting resin. The thermal curing is generally performed at 50-200 °C. By such a curing treatment, there is formed an insulating layer of the cured epoxy resin excellent in insulating property and in resistance to heat and chemicals.

The thus obtained board bearing the insulating layer may be used for preparing multi-layered printed wiring board or may be further processed to effect electromagnetic shielding of the board. These methods will be briefly described below.

Formation of Electromagnetic Shielding Layer:

An electromagnetic shielding layer is provided on the insulating layer of the board by any known suitable manner such as by coating of a conducting coating composition containing silver, copper or the like metal or by laminating a metal foil. The conducting layer is electrically connected to an earth terminal of the printed circuit board. Prior to the formation of the conducting layer, it is preferable to grind the cured resin layer (insulating layer) so as to form a flat, smooth surface. After the electromagnetic shielding layer has been formed, it is possible to form through-holes in the board by drilling at desired portions.

Electromagnetic shielding of a printed wiring board can also be made using a laminate film whose substrate film is formed of an electrically conducting material and serves to function as an electromagnetic shielding layer. That is, after press-bonding of the laminate to the conducting surface of the board, the solidified layer of the thermosetting resin is cured with the substrate film remaining as such. Since the substrate film is not removed, the bonding force between the substrate film and the cured thermosetting resin film is desired to be as high as possible.

Preparation of Multi-Layered Board:

In the past, multi-layered, printed circuit boards have been prepared by a method including the steps of providing a board having printed wiring patterns on both sides thereof, applying a coating composition to both sides of the board to form insulating layers covering the wiring patterns, and forming further wiring patterns on the insulating layers by chemical plating or by lamination of copper foils followed by etching. In the known method, the coating step for the formation of the two insulating layers cannot be performed simultaneously. Further, since the board tends to warp by the formation of the insulating layer on one side of the board, it becomes difficult to form another insulating layer on the other side of the board.

With the use of the laminate film according to the present invention, two insulating layers can be formed simultaneously without encountering the above problems of the known method. Thus, the laminate film is first pressure-bonded with heating to each of the opposite surfaces of the board. After solidification of the thermosetting resin layers, the substrate films are removed. A copper foil is then pressure- boned with heating to each of the solidified resin layers. After curing the resin layers, the copper foils are subjected to etching for the formation of desired wiring patterns, whereby a four-layered wiring board is obtained.

The laminate film according to the present invention may be used for forming an insulating layer over any other conducting surface, such as metal surfaces, than printed wiring boards.

The following examples will further illustrate the present invention.

Example 1

(1) Preparation of Thermosetting Resin Composition:

A thermosetting resin coating composition was prepared by mixing the following ingredients:

| Ingredients | Amount (% by weight) |
|---|---|
| Epikote 1001 *1 | 40 |
| Phenototo YP-50 *2 | 15 |
| Dicyanodiamide | 1 |
| Dichlorophenyldimethylurea | 2 |
| Methyl ethyl ketone | 15 |
| Methanol | 27 |

*1: Bisphenol A epoxy resin, weight epoxy equivalent: 450-500, manufactured by Yuka-Shell Epoxy Inc.
*2: Phenoxy resin, manufactured by Toto Kasei Inc.

(2) Preparation of Laminate Film:

The above coating composition was applied to one side surface of a polyethylene terephthalate film (substrate film, thickness: 50 µm, width: 250 mm) at 20 °C using an applicator. The coat was dried at 120 °C to form a thermosetting resin layer. The coated film was laminated with a polypropylene film (protecting layer) and the laminate was wound into a roll having a construction as shown in the FIGURE.

(3) Press-Bonding:

The rolled laminate film was drawn and cut into a predetermined length while removing the protecting layer. The cut film was superposed on a printed wiring board with the thermosetting resin layer being in contact with the wiring pattern-bearing surface of the board. The superposed board was then fed to a vacuum laminator to effect press-bonding of the resin layer on the wiring pattern-bearing surface with heating at 80 °C. After cooling, the substrate film was removed to obtain a wiring board whose wiring pattern-bearing surface was covered with the thermosetting resin layer.

(4) Curing:

The resulting board was then fed to a heating chamber where the thermosetting resin layer was cured at 150 °C for 2 hours, thereby to obtain a wiring board whose wiring pattern-bearing surface was covered with an insulating layer of the cured resin.

(5) Electromagnetic Shielding:

The insulating layer was ground to form a flat, smooth surface, over which a conducting coating liquid (copper paste) was applied and the coat was dried, whereby an electromagnetic shielding layer was formed on the insulating layer of the board.

Example 2

Example 1 was repeated in the same manner as described except that a copper foil with a thickness of 18 µm was used in place of the polyethylene terephthalate film to obtain a rolled laminate film. The rolled laminate film was drawn and cut into a predetermined length while removing the protecting layer. The cut film was superposed on a printed wiring board with the thermosetting resin layer being in contact with the wiring pattern-bearing surface of the board. The superposed board was then fed to a vacuum laminator to effect press-bonding of the resin layer on the wiring pattern-bearing surface with heating at 80 °C. Thereafter, the board was introduced into a heating chamber where the thermosetting resin layer was cured at 150 °C for 2 hours, thereby to obtain a wiring board whose wiring pattern-bearing surface was covered with an intermediate, insulating layer of the cured resin and a top, electromagnetic shielding layer of the copper foil.

Example 3

To a printed circuit board bearing a circuit pattern on each of the opposite sides thereof, two laminate films (each of which had a structure similar to that obtained in Example 2) were press-bonded with heating with the thermosetting resin layers of the laminate film being in contact with the circuit pattern-bearing surfaces of the board. The resulting board was heated for curing the thermosetting resin layers. Thereafter, the top copper foils were etched to form wiring patterns, whereby a four-layered, printed circuit board was obtained.

Example 4

A coating composition with the formulation shown below was coated on a polyethylene terephthalate film (width: 250 mm, thickness: 50 µm) by means of a roll coater. The resulting coat was then irradiated by UV light using three high-pressure mercury lamps (80W/cm) while conveying the coated film at a speed of 10 m/minutes beneath them, thereby to obtain a B-stage resin film on the polyethylene terephthalate film.

| Ingredients | Amount (parts by weight) |
|---|---|
| Epikote 828 *3 | 30 |
| BT-2100 *4 | 30 |
| MANDA *5 | 40 |
| Initiator *6 | 2 |

*3: Bisphenol A epoxy resin, weight epoxy equivalent: 184-194 (manufactured by Yuka-Shell Epoxy Inc.)
*4: Bismaleimide-triazine resin (manufactured by Mitsubishi Gas Chemicals Co., Ltd.)
*5: Hydroxypivalic acid neopentylglycol diacrylate
*6: 1-Hydroxycyclohexyl phenyl ketone

Example 5 below

A coating composition with the formulation shown was coated on a polyethylene terephthalate film (width: 250 mm, thickness: 50 µm) by means of a roll coater. The resulting coat was then heated at 125 °C for 10 minutes, thereby to obtain a B-stage resin film on the polyethylene terephthalate film.

| Ingredients | Amount (parts by weight) |
|---|---|
| Epikote 1001 *1 | 50 |
| MANDA *5 | 30 |
| Phenototo YP59 *2 | 20 |
| Benzoyl peroxide | 2 |
| 2-Ethyl-4-methylimidazole | 2 |

* 1, 2 and 5: the same above

Example 6

A B-stage resin film laminate was obtained in the same manner as in Example 4 except for using a 18 µm thick copper foil in place of the terephthalate film.

Example 7

The laminate film obtained in Example 4 was superposed on a printed wiring board with the B-stage resin film being in contact with the wiring pattern-bearing surface of the board and hot press-bonded thereto by vacuum lamination at 80 °C. After cooling, the terephthalate film was removed and the B-stage resin film was subjected to curing at 150 °C for 1 hour in a heating chamber. The surface of the cured resin layer was abraded to render the surface smooth, to which a conductive paint (copper paste) was coated, thereby to give a printed wiring board whose wiring pattern was covered with an electromagnetic shielding layer with the cured resin layer being interposed therebetween.

Example 8

The laminate film obtained in Example 6 was superposed on a printed wiring board with the B-stage resin layer being in contact with the wiring pattern-bearing surface thereof. After hot press-bonding them to each other, the assembly was further heated at 150 °C for 1 hour to effect curing of the B-stage resin, whereby a printed wiring board covered with an electromagnetically shielding copper foil was obtained.

Example 9

The copper foil-covered board obtained in Example 8 was subjected to an etching treatment so that the copper foil was etched to form a desired wiring pattern.

Example 10

To a printed circuit board bearing a circuit pattern on each of the opposite sides thereof, two laminate films (each of which had a structure similar to that obtained in Example 4) were press-bonded with heating with the thermosetting resin layers of the laminate film being in contact with the circuit pattern-bearing surfaces of the board. After removing the terephthalate film, the board was heated for curing the thermosetting resin layers. Thereafter, a copper foil was laminated on each of the cured resin layers, and the copper foils were etched to form wiring patterns, whereby a four-layered, printed circuit board was obtained.

## Claims

1. A laminate film comprising a substrate film and a thermosetting resin film formed of a thermosetting resin composition containing an epoxy resin and a curing agent and supported on one side surface of said substrate film.

2. A laminate film according to claim 1, wherein said thermosetting resin film is removably supported on said substrate film.

3. A laminate film according to claim 2, further comprising an intermediate layer provided between said thermosetting resin film and said substrate film and containing a releasing agent to improve the removability of said thermosetting resin film from said substrate film.

4. A laminate film according to any preceding claim, further comprising a protecting layer peelably provided over said thermosetting resin film.

5. A laminate film according to claim 4, further comprising a second intermediate layer provided between said protecting layer and said thermosetting resin film to improve the peelability of said protecting layer.

6. A laminate film according to claim 1, wherein said substrate film is an electrically conducting film.

7. A laminate film according to any preceding claim and wound in the form of a roll.

8. A laminate film according to claim 1 wound in the form of a roll and further comprising an outer layer provided on the other side of said substrate film and containing a releasing agent to prevent sticking between the top surface of said thermosetting resin film and the other side of said substrate film.

9. A laminate film according to any preceding claim, wherein said thermosetting resin composition further contains a polymer of a polymerizable compound having at least two acrylate or methacrylate groups.

10. A laminate film according to any preceding claim, wherein said curing agent is a maleimide/triazine resin.

11. A laminate film according to any preceding claim, wherein said thermosetting resin composition further contains a filler.

12. A method of forming an electrically insulating layer over an electrically conducting surface, comprising the steps of:

(a) providing a laminate film including a substrate film and a thermosetting resin film supported on one side of said substrate film and formed of a composition containing an epoxy resin;

(b) superposing said laminate film on the conducting surface with said thermosetting resin film being in contact with the conducting surface;

(c) heating said thermosetting resin film at a temperature sufficient to soften said thermosetting resin film so that said thermosetting resin film is bonded to said conducting surface;

(d) then removing said substrate film from said thermosetting resin film; and

(e) then heating said thermosetting resin film at a temperature and for a period of time sufficient to cure said thermosetting resin film, thereby to form the insulating layer formed of said cured film.

13. A method as claimed in claim 12, further comprising the step of:

(f) forming an electrically conducting layer over the surface of said insulating layer.

14. A method as claimed in claim 13, wherein the conducting surface is a first wiring pattern-bearing surface of a printed circuit board and wherein step (f) includes laminating a copper foil on said insulating layer and etching said copper foil to form a second wiring pattern thereon.

15. A method as claimed in claim 13, wherein the conducting surface is a first wiring pattern-bearing surface of a printed circuit board and wherein step (f) includes plating copper on said insulating layer to form a second wiring pattern thereon.

16. A method as claimed in claim 13, wherein the conducting surface is a first wiring pattern-bearing surface of a printed circuit board and wherein said electrically conducting layer serves to function as an electromagnetically shielding layer.

17. A method as claimed in any preceding claim, wherein said thermosetting resin composition further includes a polymer of a polymerizable compound having at least two acrylate or methacrylate groups.

18. A method of forming an electrically insulating layer over an electrically conducting surface with an electrically conducting layer being provided on the insulating layer, comprising the steps of:

(a) providing a laminate film including an electrically conducting substrate film, and a thermosetting, epoxy resin film supported on one side of said substrate film;

(b) superposing said laminate film on the conducting surface with said thermosetting resin film being in contact with the conducting surface;

(c) heating said thermosetting resin film at a temperature sufficient to soften said thermosetting resin film so that said thermosetting resin film is bonded to said conducting surface; and

(d) then heating said thermosetting resin film at a temperature and for a period of time sufficient to cure said thermosetting resin film, thereby to form the insulating layer formed of said cured film on the conducting surface with said conducting substrate being provided on the insulating layer and serving as the conducting layer.

19. A method as claimed in claim 18, wherein the conducting surface is a first wiring pattern-bearing surface of a printed circuit board, said method further comprising etching said conducting layer to form a second wiring pattern on said insulating layer.

20. A method as claimed in claim 18, wherein the conducting surface is a first wiring pattern-bearing surface of a printed circuit board and wherein said electrically conducting layer serves to function as an electromagnetically shielding layer.

21. A method as claimed in any preceding claim, wherein said thermosetting resin composition further includes a polymer obtained from a monomer containing at least two acrylate or methacrylate groups.

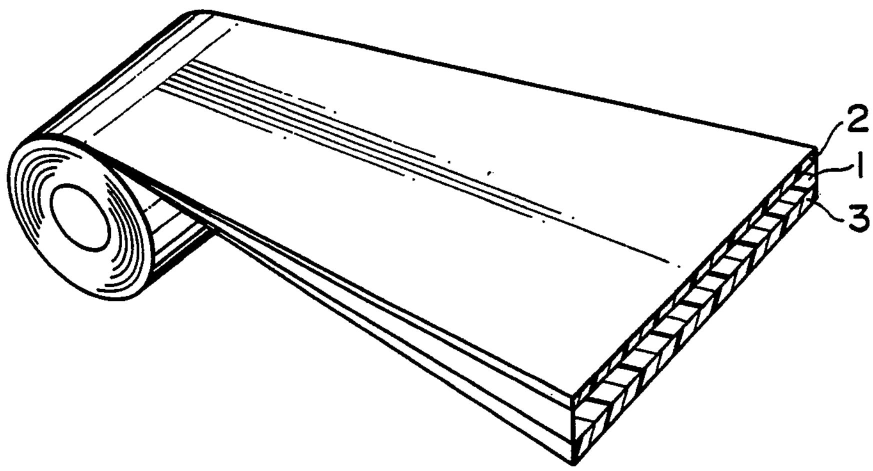
2
1
3